(19) **Europäisches Patentamt European Patent Office Office européen des brevets**

(11) **EP 4 614 227 A1**

(12) **EUROPEAN PATENT APPLICATION**

(43) Date of publication:
**10.09.2025 Bulletin 2025/37**

(21) Application number: **24161848.7**

(22) Date of filing: **06.03.2024**

(51) International Patent Classification (IPC):
$G03F\ 7/00^{(2006.01)}$  $G03F\ 9/00^{(2006.01)}$

(52) Cooperative Patent Classification (CPC):
**G03F 7/706833; G03F 7/705; G03F 7/70616; G03F 9/7046**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
- **MAYANK, Mayank**
  **5500 AH Veldhoven (NL)**
- **HULSEBOS, Edo Maria**
  **5500 AH Veldhoven (NL)**
- **ROOZE, Joost**
  **5500 AH Veldhoven (NL)**
- **RAAIJMAKERS, Youri**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD OF DETERMINING A SAMPLING SCHEME, ASSOCIATED APPARATUS AND COMPUTER PROGRAM**

(57) Disclosed is a method of configuring a sampling scheme for a metrology operation comprising: obtaining metrology data relating to measurements on a substrate; fitting a first model to the metrology data to obtain a first fitted model; evaluating the first fitted model on an evaluation grid; calculating a noise propagation coefficient for each candidate measurement location of a plurality of candidate measurement locations based on said evaluation, and configuring the sampling scheme based on the calculation step.

**Fig. 2**

EP 4 614 227 A1

**Description**

FIELD

The present invention relates to a method of determining a sampling scheme for metrology, an associated apparatus and a computer program.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Whichever type of apparatus is employed, the accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. These operations, being time-consuming, limit the throughput of the lithography apparatus, and consequently increase the unit cost of the semiconductor or other products.

As pattern features become smaller and overlay performance requirements become ever more demanding, so-called advanced alignment models have been and continue to be developed to model and correct more accurately non-linear distortions of the wafer 'grid'. These advanced models depend on measuring an increased number of targets across the wafer. Ultimately, however only a limited number of the available targets can be measured without unduly limiting the throughput and/or costs of the lithographic process as a whole.

SUMMARY

In a first aspect of the invention there is provided a method of configuring a sampling scheme for a metrology operation comprising: obtaining metrology data relating to measurements on a substrate; fitting a first model to the metrology data to obtain a first fitted model; evaluating the first fitted model on an evaluation grid; calculating a noise propagation coefficient for each candidate measurement location of a plurality of candidate measurement locations based on said evaluation, and configuring the sampling scheme based on the calculation step. In an embodiment of first aspect of the invention, the method is a computed-implemented method and/or is a method carried out by a computer.

These and other features and advantages of particular embodiments of the invention will be understood by the skilled reader from a consideration of the exemplary embodiments discussed below.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1(a) depicts a lithographic apparatus according to an embodiment of the invention;
Figure 1(b) illustrates schematically the stages in the measurement and exposure processes in the apparatus of Figure 1(a), according to known practice;
Figure 2 is a flowchart describing a sampling scheme optimization method according to concepts disclosed herein; and
Figure 3 illustrates computer system hardware useful in implementing the processes disclosed herein.

DETAILED DESCRIPTION OF EXEMPLARY EMBODIMENTS

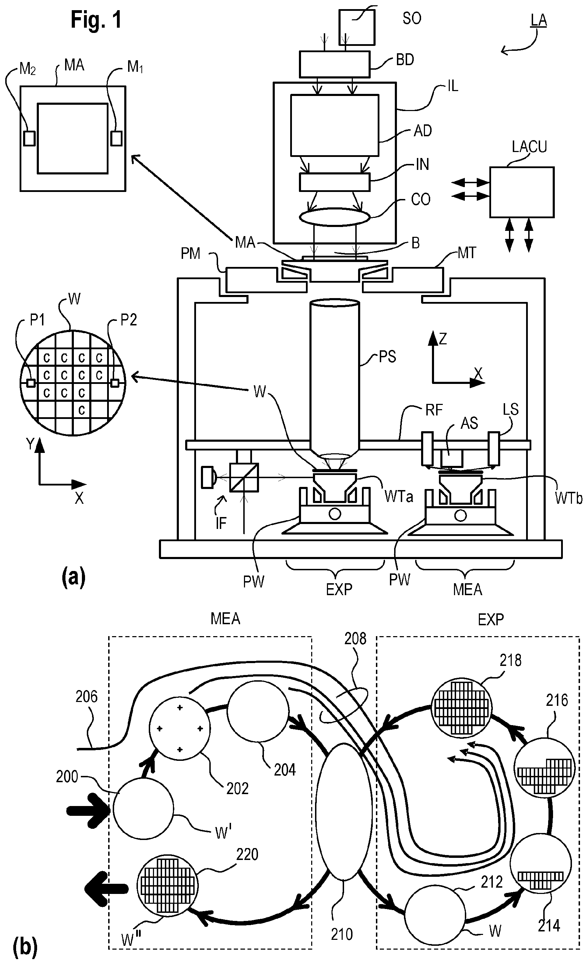

Figure 1(a) schematically depicts a lithographic apparatus LA according to one embodiment of the invention. The apparatus comprises:

- an illumination system (illuminator) IL configured to condition a radiation beam B (e.g. UV radiation or EUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WTa or WTb constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure. The invention disclosed herein can be used in a stand-alone fashion, but in particular it can provide additional functions in the pre-exposure measurement stage of either single- or multi-stage apparatuses.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1(a), the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1(a)) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:

1. In step mode, the mask table MT and the substrate table WTa/WTb are kept essentially stationary, while an entire pattern imparted to the radiation beam is projected onto a target portion C at one time (i.e. a single static exposure). The substrate table WTa/WTb is then shifted in the X and/or Y direction so that a different target portion C can be exposed. In step mode, the maximum size of the exposure field limits the size of the target portion C imaged in a single static exposure.

2. In scan mode, the mask table MT and the substrate table WTa/WTb are scanned synchronously while a pattern imparted to the radiation beam is projected onto a target portion C (i.e. a single dynamic exposure). The velocity and direction of the substrate table WTa/WTb relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning device, and the substrate table WTa/WTb is moved or scanned while a pattern imparted to the radiation beam is projected onto a target portion C. In this mode, generally a pulsed radiation source is employed and the programmable patterning device is updated as required after each movement of the substrate table WTa/WTb or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Lithographic apparatus LA in this example is of a so-called dual stage type which has two substrate tables WTa and WTb and two stations - an exposure station and a measurement station-between which the substrate tables can be exchanged. While one substrate on one substrate table is being exposed at the exposure station EXP, another substrate can be loaded onto the other substrate table at the measurement station MEA so that various preparatory steps may be carried out. The preparatory steps may include mapping the surface of the substrate using a level sensor LS and measuring the position of alignment mark on the substrate using an alignment sensor AS. This enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. The invention can be applied in apparatus with only one substrate table, or with more than two.

The apparatus further includes a lithographic apparatus control unit LACU which controls all the movements and measurements of the various actuators and sensors described. LACU also includes signal processing and data processing capacity to implement desired calculations relevant to the operation of the apparatus. In practice, control unit LACU will be realized as a system of many subunits, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

Figure 1(b) illustrates the known steps to expose target portions (e.g. dies) on a substrate W in the dual stage apparatus of Figure 1(a). On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus. Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured, to establish a "wafer grid", which maps very accurately the distribution of marks across the substrate, including any distortion relative to a nominal rectangular grid. At step 204, a map of wafer height against X-Y position is measured also, for use in accurate focusing of the exposed pattern.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure stage. The measurements of alignment data for example comprise X and Y positions of alignment targets formed in a fixed or nominally fixed relationship to the product patterns that are the product of the lithographic process. These alignment data, taken just before exposure, are combined and interpolated to provide parameters of an alignment model. These parameters and the alignment model will be used during the exposure operation to correct positions of patterns applied in the current lithographic step. A conventional alignment model might comprise four, five or six parameters, together defining translation, rotation and scaling of the 'ideal' grid, in different dimensions. As described further below, advanced models are known that use more parameters.

At 210, wafers W' and W are swapped, so that the measured substrate W' becomes the substrate W entering the exposure station EXP. This swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns. By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The concepts disclosed herein will mainly be described in the context of overlay metrology and/or alignment metrology. However, this must not be taken as a limitation to such contexts; the concepts herein are applicable to any metrology, using a multiple sensor setup, of a proper subset of multiple potential measurement points. In any such context, a sampling scheme optimization to determine the proper subset can be expected to provide a benefit. Therefore, while alignment models will now be described for purposes of exemplary illustration, the concepts disclosed herein can also be used, for example, with exposure-dose correction models, and/or with focus correction models. Such models are well known to the skilled person and will not be described in any detail.

Advanced Alignment Models

Basic alignment models may have six parameters (effectively three per direction X & Y) with more advanced alignment models comprising many more parameters. For more demanding processes, to achieve the desired overlay performance requires more detailed corrections of the wafer grid and advanced alignment models have been developed for this purpose. In this text, 'advanced' alignment models refers to all type of models with more complexity than the standard six parameters. While standard models might use fewer than ten parameters, advanced alignment models typically use more than 15 parameters, or more than 30 parameters. Examples of advanced models are higher order wafer alignment (HOWA) models, zone-alignment (ZA) and radial basis function (RBF) based alignment models. HOWA is a published technique based on third and higher order polynomial functions. Zone alignment is described for example in Huang et al, "Overlay improvement by zone alignment strategy", Proc. SPIE 6922, 69221G (2008), which is incorporated herein by reference. Different versions and extensions of these advanced models can be devised. The advanced models generate a complex description of the wafer grid that is corrected for, during the exposure of the target layer. RBF and latest versions of HOWA provide particularly complex descriptions based on tens of parameters This implies a great many measurements are required to obtain a wafer grid with sufficient detail.

Even in embodiments with multiple substrate tables WTa/WTb, the time taken to obtain sufficient measurements for advanced alignment on each wafer eventually impacts throughput. Reducing the time per measurement tends to decrease the accuracy of each measurement, so that the impact on throughput is hard to avoid. In addition, once corrections have been applied in one layer using an advanced alignment model, the same level of detail should be applied in subsequent layers, or the corrections in the first layer become a source of error in the overlay of subsequent layers. The manufacturer therefore has a difficult choice whether to accept further measurement overhead by using the advanced model in subsequent layers, or to suffer an overlay penalty by reverting to a simpler alignment model in subsequent layers, measuring fewer marks.

There is a large degree of similarity in the problems faced for alignment and model estimation / correction calculation. The commonality is that a certain systematic pattern is estimated using a limited set of measurements taken at certain locations. The positions from which measurements are selected for inclusion in the estimation process, determines how reliable the resulting model is. This is because not all measurement positions are necessarily equally informative for the estimation procedure.

Some HVM (High Volume Manufacturing) measurement schemes sample a couple of fields on the substrate densely while covering the rest of the substrate in a sparse fashion (e.g. one metrology point per field). This is already suboptimal for the more basic models, and more serious problems begin to occur for higher order models. This applies to metrology performed for alignment (e.g., using an alignment sensor to align the substrate with respect to projection optics prior to exposure) and post-exposure metrology for process monitoring.

In a lithographic apparatus such as shown in Figure 1(a), alignment is performed for each substrate prior to exposure. Multiple metrology points (e.g., alignment marks) are used to capture the shape of the substrate and to average out placement noise (e.g., originating from the lithographic apparatus baseline). Additionally, to monitor the process and determine corrections therefor as part of a process control arrangement, a post-exposure metrology tool (e.g., a scatterometry based tool or e-beam tool) may be used to measure a parameter of interest (e.g., overlay, focus, critical dimension or any other metric) from multiple metrology points (e.g., metrology targets). In each case, several measurement targets may be placed in each field on the wafer. To limit the cost of metrology only a subset of these possible measurement locations are actually measured and used as input for a control algorithm that determines from these measurements the appropriate stage position and/or other exposure parameters (e.g., focus dose etc.) and corrections (over the field, over the wafer, over the lot) for the lithographic exposure system or other processing equipment.

Some current algorithms for determining which metrology locations are sampled from a set of candidate measurement locations (e.g., in the context of alignment metrology, overlay metrology, focus metrology, dose metrology, contrast metrology or other metrology of structures, targets or marks formed by a lithographic process) attempt to sample the substrate in a uniform fashion, uniformity being defined as being equal distances between neighboring metrology locations. This is sometimes referred to as equidistance mark selection (EMS). Such a method may be implemented as a greedy strategy (i.e., once selected, locations cannot then be unselected). Locations may be selected individually from the available candidate locations at each selection step. The selected location may be that assessed as the next most valuable metrology location according to a distance metric (i.e., maximizing distance from already selected locations).

A variation on such an approach may use the distance metric to determine a subset of the candidate locations which are distant from already selected locations, followed by a step of choosing a single location from the subset based on a normalized model uncertainty metric.

For example, WO2015/110191 (which is incorporated herein by reference) describes methods for determining a measurement scheme or sampling scheme (e.g., describing which metrology locations are to be measured from all available metrology locations), which may be referred to as sample scheme optimization (SSO). Such a method comprises evaluating candidate metrology locations; for example, to determine how much the informativity of the sample scheme would improve if that metrology location were selected. This may comprise evaluating all candidate metrology locations and selecting the one which is determined will add the most information for the measurement scheme. More specifically, each selected metrology location may have an associated exclusion zone around it and candidate locations may comprise only potential metrology locations located outside of these exclusion zones. This ensures that the overall sampling scheme is distributed sufficiently over the substrate.

Present methods such as those described do not always enable use of the same model for the sampling scheme optimization as will be used to model the metrology data (e.g., the alignment model in an alignment context); however it is typically preferred to use the same model for sampling selection as for metrology data modeling. For example, RBF models and/or regularized models may be the preferred model for data representation, but such models cannot be used in many of the sampling scheme determination methods described. In addition, many of the methods described herein use EMS either as the main strategy or as a starting point to select an initial few locations. In either case, EMS typically does not perform as well as other methods.

As such, a method for configuring a sampling scheme for metrology apparatus is proposed comprising obtaining metrology data relating to measurements on a substrate; fitting a first model to the metrology data to obtain a first fitted model; evaluating the first fitted model on an evaluation grid, (e.g., where said evaluation grid defines a plurality of candidate locations); calculating a noise propagation coefficient (e.g., a scheme factor) for each candidate measurement location of a plurality of candidate measurement locations based on said evaluation, and configuring the sampling scheme based on the calculation step, e.g., to comprise those candidate locations having the lowest noise propagation coefficient.

The first model may be the model that is to be used for to model the metrology data for the proposed metrology action (e.g., the chosen alignment model) or a proxy therefor. The first model may be regularized.

A proxy may be used, for example, when sampling scheme optimization cannot be used on the first model. By way of specific example, the first model may be a polynomial model (e.g., of 5th order or less, or of 3rd order) or an RBF model. By way of another specific example, if the first model is a regularized RBF model (e.g., a bending energy-regularized RBF model) on which SSO cannot be performed directly, the proxy model may comprise a regularized (e.g., a bending energy-regularized) polynomial model (e.g., a higher order polynomial model such as 3rd order or higher or 5th order or higher). Other first models may comprise a Zernike model or Bessel model.

The evaluation grid may be a relatively dense (with respect to the first model grid), e.g., the grid used to presently model overlay in post-exposure overlay metrology or a similarly dense grid (e.g., a 13x19 points-per-field grid). In an embodiment, the evaluation grid may be based on a different model than the first model grid.

The scheme factor may be determined per candidate measurement location, so as to represent how much noise is propagating through the model in dependence with candidate measurement location selected (i.e., in dependence on the sampling scheme).

After calculating the scheme factor at each measurement location, the measurement locations with the lowest scheme factor may be selected for the measurement layout. For example, the number of measurement locations selected for the measurement layout may be preselected depending on the metrology strategy/model and/or throughput/speed requirements. Alternatively, the number of measurement locations may be varied based on an average or total scheme factor threshold for the chosen measurement locations being met. A combination of these approaches is also possible (e.g., using the latter approach unless a maximum number of measurement locations is reached).

A number of specific implementations will now be described. In an unregularized example, the fitted model may that which minimizes $\|dx - Mc\|$ where $M$ is the model matrix, $dx$ is the metrology data (e.g., alignment data), and $c$ is the fitting coefficient or model parameter, where $c = (M^T M)^{-1} M^T dx$.

The metrology data evaluated on an evaluation grid $dx_{ev} = M_{ev} c = M_{ev}(M^T M)^{-1} M^T dx$, where $M_{ev}$ is the model matrix evaluated on an evaluation grid. The scheme factor can be calculated as:

$$SF = \sqrt{\frac{\mathrm{mean}\left(\mathrm{diag}(dx_{ev}\, dx_{ev}^T)\right)}{\mathrm{mean}\left(\mathrm{diag}(dx\, dx^T)\right)}}$$

It can be assumed that the alignment noise (output noise) is uncorrelated and has constant strength over the wafer such that $dx\, dx^T = I$, and therefore the scheme factor may be determined as:

$$SF = \sqrt{\mathrm{mean}\left(\mathrm{diag}(dx_{ev}\, dx_{ev}^T)\right)} = \sqrt{\mathrm{mean}\left(\mathrm{diag}\left(M_{ev}(M^T M)^{-1} M_{ev}^{T}\right)\right)}$$

Calculating the scheme factor on the evaluation grid is computationally expensive as the evaluation grid (and therefore the matrix $M_{ev}$) is very large. Therefore, in an embodiment, it is proposed to orthogonalize the first model onto the evaluation grid and use the Parseval relation to determine the scheme factor from the resulting new model or second model $M_{new}$. Defining:

$$M_{ev} = QR, \quad M_{new} = M * R^{-1}$$

then:

$$SF = \sqrt{\mathrm{mean}\big(\mathrm{diag}(QR(R^T M_{new}^T M_{new} R)^{-1} R^T Q^T)\big)}$$

$$= \sqrt{\mathrm{mean}\big(\mathrm{diag}(Q(M_{new}^T M_{new})^{-1} Q^T)\big)}$$

The Parseval relationship results from the fact that the columns of $Q$ are orthonormal, which implies the scheme factor can be calculated by:

$$SF = \sqrt{\mathrm{mean}\big(\mathrm{diag}((M_{new}^T M_{new})^{-1})\big)}$$

In the regularized case where $E$ is the regularization matrix (e.g., such that the model minimizes $\|dx - Mc\| + E$), then metrology data evaluated on an evaluation grid is:

$$dx_{ev} = M_{ev} c = M_{ev}(M^T M + E)^{-1} M^T dx$$

and the scheme factor is:

$$SF = \sqrt{\mathrm{mean}\big(\mathrm{diag}(dx_{ev}\, dx_{ev}^T)\big)}$$

$$= \sqrt{\mathrm{mean}(\mathrm{diag}(M_{ev}(M^T M + E)^{-1} M^T M (M^T M + E)^{-1}) M_{ev}^T)}$$

As before, the calculation may be simplified by orthogonalizing the first model onto the evaluation grid:

$$SF$$
$$= \sqrt{\mathrm{mean}(\mathrm{diag}(Q(M_{new}^T M_{new} + (R^{-1})^T E R^{-1})^{-1}) M_{new}^T M_{new} (M_{new}^T M_{new} + (R^{-1})^T E R^{-1})^{-1} Q^T)}$$

and using the Parseval relation:

$$SF = \sqrt{\mathrm{mean}(\mathrm{diag}((M_{new}^T M_{new} + (R^{-1})^T E R^{-1})^{-1}) M_{new}^T M_{new} (M_{new}^T M_{new} + (R^{-1})^T E R^{-1})^{-1})}$$

In an embodiment, the scheme factor may be used to initialize the SSO, e.g., by working on a subspace of the model, which can be selected by using a truncation of the singular value decomposition of matrix $M_{new}$; e.g., a subset of the candidate measurement locations, such as those of a particular substrate region (e.g., a peripheral region of the substrate), rather than using an EMS based initialization.

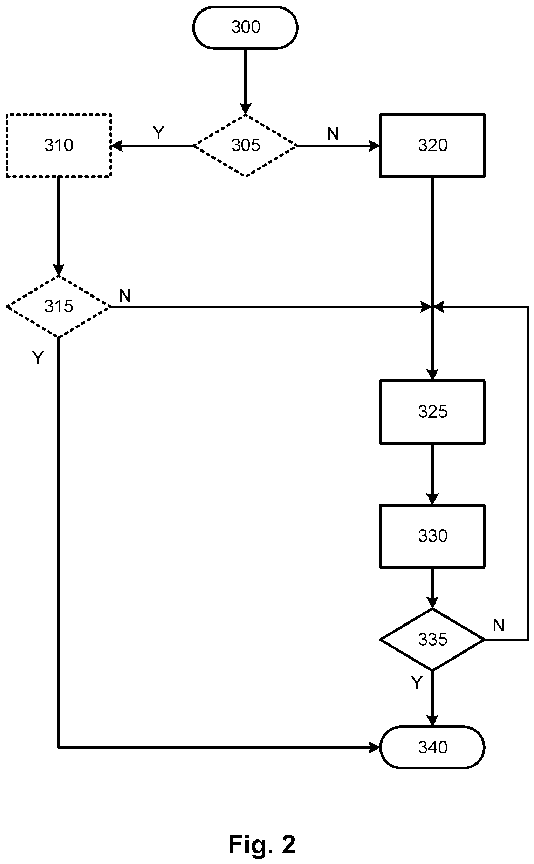

Figure 2 is a flowchart describing a method of determining a sampling scheme according to an embodiment. The method starts at step 300, and at optional step 305 it is determined whether any measurement locations are to be preselected. In present SSO methods, preselection is required. However in the methods disclosed herein no preselection is necessary and therefore this step 305 (and steps 310, 315) are purely optional, as signified by the broken lines. If there is to be a preselection of measurement locations (yes Y at step 305) then the preselected measurement locations are added 310 and a determination is made as to whether the scheme comprises sufficient measurement locations 315. If yes Y, the method finishes 340; if in the more likely event there is insufficient measurement locations (no N at step 315), the method proceeds to step 325.

In an alternative to preselection at step 305, a first measurement location may be selected 320 in a first step according to the scheme factor. For example, the first measurement location may be selected as that comprising the largest (e.g., root-mean-square RMS) orthonormal model value (i.e., the lowest 1D scheme factor $SF_{1D}$). As such, a mark location is identified for which the model functions have the strongest value when RMS is calculated over all model functions. This may comprise calculating the RMS over the model matrix rows for each measurement location and then selecting the measurement location with highest RMS value. This is only an example of selecting a first measurement location, other methods are possible.

At step 325, a distance metric may be used to determine a subset of the candidate measurement locations, e.g., those which are distant or furthest from the already selected measurement location(s). Any suitable distance metric may be used to determine the subset of measurement locations based on distance from measurement locations already selected. The subset may be selected to maximize a distance from the subset of measurement locations and the already selected measurement locations.

At step 330, a measurement location is selected from the subset defined at step 325 based on the scheme factor as has been disclosed above. This may comprise selecting the measurement location from the subset which has the lowest scheme factor. The method may comprise selecting a single measurement location for each iteration of this flow diagram. This step may use one or more of a regularized model, proxy model, orthogonalized model plus Parseval simplification as has been disclosed herein. The scheme factor may be calculated using any of the equations for scheme factor SF described above. By way of a specific example, the measurement location having the lowest scheme factor for the regularized model after orthonormalization may be added at this step.

At step 335, a determination is made as to whether the scheme comprises sufficient measurement locations 315. If yes Y, the method finishes 340; if no N, the method returns to step 325.

It can be appreciated in the above that the model matrices (and derived matrices) may comprise separate matrices $M_x$ for deformation in the x direction and $M_y$ for deformation in the y direction.

The proposed method enables generation of a layout or sampling scheme for any metrology model. The proposed method may be used to generate a sampling scheme for any of, for example, alignment metrology, overlay metrology, focus metrology, dose metrology.

Implementation

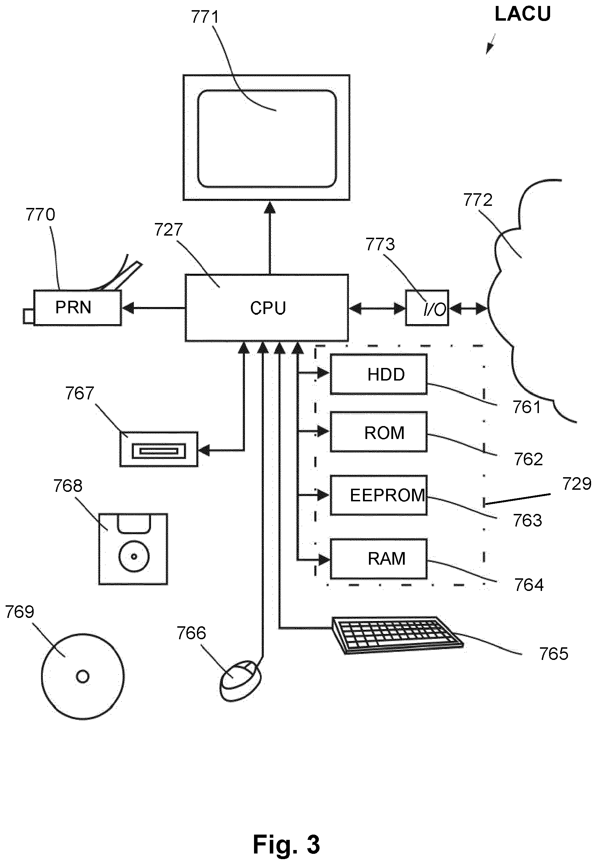

The steps of the methods described above can be automated within the lithography apparatus control unit LACU shown in Figure 1(a). This unit LACU may include a computer assembly as shown in Figure 3. The computer assembly may be a dedicated computer in the form of a control unit in embodiments of the assembly according to the invention or, alternatively, be a central computer controlling the lithographic projection apparatus. The computer assembly may be arranged for loading a computer program product comprising computer executable code. This may enable the computer assembly, when the computer program product is downloaded, to control aforementioned uses of a lithographic apparatus with embodiments of the level and alignment sensors AS, LS.

Memory 729 connected to processor 727 may comprise a number of memory components like a hard disk 761, Read Only Memory (ROM) 762, Electrically Erasable Programmable Read Only Memory (EEPROM) 763 and/or Random Access Memory (RAM) 764. Not all aforementioned memory components need to be present. Furthermore, it is not essential that aforementioned memory components are physically in close proximity to the processor 727 or to each other. They may be located at a distance away.

The processor 727 may also be connected to some kind of user interface, for instance a keyboard 765 or a mouse 766. A touch screen, track ball, speech converter or other interfaces that are known to persons skilled in the art may also be used.

The processor 727 may be connected to a reading unit 767, which is arranged to read data, e.g. in the form of computer executable code, from and under some circumstances store data on a data carrier, like a floppy disc 768 or a CDROM 769. Also DVD's or other data carriers known to persons skilled in the art may be used.

The processor 727 may also be connected to a printer 770 to print out output data on paper as well as to a display 771, for instance a monitor or LCD (Liquid Crystal Display), of any other type of display known to a person skilled in the art.

The processor 727 may be connected to a communications network 772, for instance a public switched telephone network (PSTN), a local area network (LAN), a wide area network (WAN) etc. by means of transmitters/receivers 773 responsible for input/output (I/O). The processor 727 may be arranged to communicate with other communication systems via the communications network 772. In an embodiment of the invention external computers (not shown), for instance personal computers of operators, can log into the processor 727 via the communications network 772.

The processor 727 may be implemented as an independent system or as a number of processing units that operate in parallel, wherein each processing unit is arranged to execute sub-tasks of a larger program. The processing units may also be divided in one or more main processing units with several sub-processing units. Some processing units of the processor 727 may even be located a distance away of the other processing units and communicate via communications network 772. Connections between modules can be made wired or wireless.

The computer system can be any signal processing system with analogue and/or digital and/or software technology arranged to perform the functions discussed here.

The following clauses describe embodiments of the concepts disclosed herein:

1. A method for configuring a sampling scheme for a metrology operation comprising:

  obtaining metrology data relating to measurements on a substrate;
  fitting a first model to the metrology data to obtain a first fitted model;
  evaluating the first fitted model on an evaluation grid;
  calculating a noise propagation coefficient for each candidate measurement location of a plurality of candidate measurement locations based on said evaluation, and
  configuring the sampling scheme based on the calculation step.

2. A method according to clause 1, wherein said configuring step comprises selecting the candidate measurement locations comprising the lowest noise propagation coefficients.

3. A method according to clause 1 or 2, wherein the first model comprises a model that is to be used for to model the metrology data for the proposed metrology operation.

4. A method according to clause 1 or 2, wherein the first model comprises a proxy for a model that is to be used for to model the metrology data for the proposed metrology operation.

5. A method according to any preceding clause, wherein the first model is a regularized model.

6. A method according to clause 5, wherein the first model is a bending energy-regularized model.

7. A method according to any preceding clause, wherein the first model is a polynomial model.

8. A method according to any preceding clause, wherein the noise propagation coefficient quantifies the noise propagating through the model in dependence with the candidate measurement locations selected.

9. A method according to any preceding clause, wherein the noise propagation coefficient is determined from an autocorrelation of the metrology data as evaluated on the evaluation grid.

10. A method according to any preceding clause, wherein the number of measurement locations selected in said configuring step is preselected.

11. A method according to any preceding clause, wherein the number of measurement locations selected in said configuring step is variable based on an average or total noise propagation coefficient threshold for the chosen measurement locations being met.

12. A method according to any preceding clause, wherein said calculating a noise propagation coefficient comprises orthogonalizing the first model onto the evaluation grid to determine a second model and calculating the noise propagation coefficient based on the second model.

13. A method according to clause 12, wherein said calculating step calculates the noise propagation coefficient from an autocorrelation of a model matrix representing the second model.

14. A method according to any preceding clause, wherein said noise propagation coefficient is used to initialize the sampling scheme configuration based on a subset of said candidate measurement locations.

15. A method according to any preceding clause, wherein said plurality of candidate locations is defined by said evaluation grid.

16. A method according to any preceding clause, comprising an initial step of selecting a first candidate measurement location based on a determined orthonormal model value for said first model.

17. A method according to clause 16, comprising selecting said first candidate measurement location as that comprising the largest root-mean-square orthonormal model value for said first model.

18. A method according to any preceding clause, comprising selecting a measurement location from said candidate measurement locations by multiple iterations of:

  determining a subset of candidate measurement locations based on a distance metric to already selected measurement locations;
  determining said noise propagation coefficient for each candidate measurement location of said subset of candidate measurement locations; and
  selecting a measurement location from said subset of candidate measurement locations based on the determined noise propagation coefficients.

19. A method according to any preceding clause, wherein the metrology data comprises alignment data, overlay data, focus data, contrast data or dose data.

20. A method according to any preceding clause, comprising the step of performing a metrology operation in accordance with said sampling scheme.

21. A method according to clause 20, wherein the metrology operation comprises an alignment operation, overlay, any product dimension, focus and/or dose monitoring operation, or any combination thereof.

22. A method according to any preceding clause, wherein said method comprises a computer implemented method.

23. A computer program comprising computer readable instructions which, when run on suitable processor, cause the processor to perform the method of any one of clauses 1 to 22.

24. A computer program product comprising the computer program of clause 23.

25. A metrology apparatus comprising:

a metrology sensor arrangement;
a processor; and
a storage device comprising the computer program of clause 23.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "field"/"die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below. In addition, it should be appreciated that structural features or method steps shown or described in any one embodiment herein can be used in other embodiments as well.

## Claims

1.  A method for configuring a sampling scheme for a metrology operation comprising:

obtaining metrology data relating to measurements on a substrate;
fitting a first model to the metrology data to obtain a first fitted model;
evaluating the first fitted model on an evaluation grid;
calculating a noise propagation coefficient for each candidate measurement location of a plurality of candidate measurement locations based on said evaluation, and
configuring the sampling scheme based on the calculation step.

**2.** A method as claimed in claim 1, wherein said configuring step comprises selecting the candidate measurement locations comprising the lowest noise propagation coefficients.

**3.** A method as claimed in claim 1 or 2, wherein the first model comprises a model that is to be used for to model the metrology data for the proposed metrology operation.

**4.** A method as claimed in claim 1 or 2, wherein the first model comprises a proxy for a model that is to be used for to model the metrology data for the proposed metrology operation.

**5.** A method as claimed in any preceding claim, wherein the first model is a regularized model.

**6.** A method as claimed in claim 5, wherein the first model is a bending energy-regularized model.

**7.** A method as claimed in any preceding claim, wherein the first model is a polynomial model.

**8.** A method as claimed in any preceding claim, wherein the noise propagation coefficient quantifies the noise propagating through the model in dependence with the candidate measurement locations selected.

**9.** A method as claimed in any preceding claim, wherein the noise propagation coefficient is determined from an autocorrelation of the metrology data as evaluated on the evaluation grid.

**10.** A method as claimed in any preceding claim, wherein said calculating a noise propagation coefficient comprises orthogonalizing the first model onto the evaluation grid to determine a second model and calculating the noise propagation coefficient based on the second model.

**11.** A method as claimed in claim 10, wherein said calculating step calculates the noise propagation coefficient from an autocorrelation of a model matrix representing the second model.

**12.** A method as claimed in any preceding claim, wherein said noise propagation coefficient is used to initialize the sampling scheme configuration based on a subset of said candidate measurement locations.

**13.** A method according to any preceding claim, comprising an initial step of selecting a first candidate measurement location based on a determined orthonormal model value for said first model.

**14.** A computer program and/or computer program product comprising computer readable instructions which, when run on suitable processor, cause the processor to perform the method of any one of claims 1 to 13.

**15.** A metrology apparatus comprising:

a metrology sensor arrangement;
a processor; and
a storage device comprising the computer program or computer program product of claim 14.

**Fig. 1**

(a)

(b)

**Fig. 2**

**Fig. 3**

Europäisches
Patentamt

European
Patent Office

Office européen
des brevets

# EUROPEAN SEARCH REPORT

**Application Number**

EP 24 16 1848

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/155698 A1 (VAN DE RUIT KEVIN [NL] ET AL) 19 May 2022 (2022-05-19) * paragraphs [0008] - [0010], [0059], [0060] * | 1-15 | INV. G03F7/00 G03F9/00 |
| A | US 2017/242425 A1 (BUHL STEFAN [DE] ET AL) 24 August 2017 (2017-08-24) * paragraphs [0010], [0054], [0055]; figure 1B * | 1-15 | |
| A | REN ALEX ET AL: "Alignment sampling by thorough run-to-run simulation", SPIE PROCEEDINGS; [PROCEEDINGS OF SPIE ISSN 0277-786X], SPIE, US, vol. 10959, 26 March 2019 (2019-03-26), pages 1095920-1095920, XP060119226, DOI: 10.1117/12.2515001 ISBN: 978-1-5106-3673-6 * the whole document * | 1-15 | |

| | | | TECHNICAL FIELDS SEARCHED (IPC) |
|---|---|---|---|
| | | | G03F |

The present search report has been drawn up for all claims

| Place of search | Date of completion of the search | Examiner |
|---|---|---|
| Munich | 26 August 2024 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 1848

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2024

| Patent document cited in search report | Publication date | Patent family member(s) | | Publication date |
|---|---|---|---|---|
| US 2022155698 A1 | 19-05-2022 | CN | 113632011 A | 09-11-2021 |
| | | EP | 3948422 A1 | 09-02-2022 |
| | | KR | 20210129703 A | 28-10-2021 |
| | | TW | 202043915 A | 01-12-2020 |
| | | US | 2022155698 A1 | 19-05-2022 |
| | | WO | 2020193367 A1 | 01-10-2020 |
| US 2017242425 A1 | 24-08-2017 | KR | 20170098709 A | 30-08-2017 |
| | | TW | 201740235 A | 16-11-2017 |
| | | US | 2017242425 A1 | 24-08-2017 |

EPO FORM P0459

For more details about this annex : see Official Journal of the European Patent Office, No. 12/82

## REFERENCES CITED IN THE DESCRIPTION

**Patent documents cited in the description**

- WO 2015110191 A

**Non-patent literature cited in the description**

- **HUANG et al.** Overlay improvement by zone alignment strategy. *Proc. SPIE 6922, 69221G*, 2008